## Europäisches Patentamt
## European Patent Office
## Office européen des brevets

(19)

(11) Veröffentlichungsnummer : **0 382 880 B1**

(12)
# EUROPÄISCHE PATENTSCHRIFT

(45) Veröffentlichungstag der Patentschrift :
**15.04.92 Patentblatt 92/16**

(51) Int. Cl.$^5$ : **G01D 11/28, B60Q 3/04**

(21) Anmeldenummer : **89110100.8**

(22) Anmeldetag : **03.06.89**

(54) **Zeigerinstrument.**

(30) Priorität : **16.02.89 DE 3904656**

(43) Veröffentlichungstag der Anmeldung :
**22.08.90 Patentblatt 90/34**

(45) Bekanntmachung des Hinweises auf die
Patenterteilung :
**15.04.92 Patentblatt 92/16**

(84) Benannte Vertragsstaaten :
**DE ES FR GB IT**

(56) Entgegenhaltungen :
**DE-A- 3 139 004**
**DE-A- 3 331 724**
**US-A- 3 267 598**
**US-A- 4 257 084**

(56) Entgegenhaltungen :
**PATENT ABSTRACTS OF JAPAN vol. 149, no. 010 (P-461)() 30 Mai 86, & JP-A-61 003010 (DAIHATSU KOGYO KK) 09 Januar 86,**
**PATENT ABSTRACTS OF JAPAN vol. 052, no. 004 (E-007)() 18 April 80, & JP-A-55 024404 (TOSHIBA CORP) 21 Februar 80,**

(73) Patentinhaber : **VDO Adolf Schindling AG**
**Gräfstrasse 103**
**W-6000 Frankfurt/Main 90 (DE)**

(72) Erfinder : **Sell, Gerhard**
**Feldstrasse 3**
**W-6231 Schwalbach/Ts. (DE)**

(74) Vertreter : **Klein, Thomas, Dipl.-Ing. (FH)**
**Sodener Strasse 9 Postfach 6140**
**W-6231 Schwalbach a. Ts. (DE)**

## Beschreibung

Die Erfindung betrifft ein Zeigerinstrument mit einem von wenigstens einer Leuchtdiode beleuchteten Lichtleiter, nach der Gattung des Patentanspruchs. Solche Zeigerinstrumente sind in heutigen Kraftfahrzeugen gebräuchlich und deshalb allgemein bekannt.

Bei Zeigerinstrumenten ist es oftmals wünschenswert, daß sich die Farbe der Beleuchtung in Abhängigkeit von der Zeigerstellung verändert. Bei einer Füllstandsanzeige kann man beispielsweise bei Unterschreiten einer Reservemenge die Beleuchtung von weiß auf rot wechseln lassen, um dem Fahrer diesen Zustand auffallend zu signalisieren. Um einen solchen Farbwechsel zu ermöglichen, sind in den bisherigen Anzeiginstrumenten zumindest zwei Lichtquellen mit unterschiedlicher Farbe vorgesehen. Dadurch wird das Anzeigeinstrument relativ aufwendig.

Aus dem Dokument DE-A1-31 39 004 ist es bereits bekannt, in einer Bedienungsknopfanzeigevorrichtung in jedem Bedienungsknopf eine 2-Farben-Leuchtdiode anzuordnen und je nach dem Schaltzustand des durch den betreffenden Bedienungsknopf angesteuerten Gerätes mit unterschiedlicher Spannung anzusteuern, so daß dieser entsprechend in unterschiedlichen Farben aufleuchtet.

In dem Dokument JP-A-61 003 010 ist ein Zeigerinstrument mit einem lichtleitenden Zeiger offenbart, der durch einen feststehenden Lichtleiter ragt und im allgemeinen durch diesen mit Licht beaufschlagt ist. Zusätzlich weist der lichtleitende Schaft des Zeigers eine mit einem Fenster versehene abgedeckte Ringzone auf, die punktförmig durch eine zweite andersfarbige Lichtquelle angestrahlt wird. Wenn der Zeiger eine solche Stellung einnimmt, daß das Fenster vor dieser Lichtquelle steht, erstrahlt der Zeiger in dem andersfarbigen Licht.

Aus dem Dokument US-A-4 257 084 ist eine Anzeigeeinrichtung mit einem Lichtleiter bekannt, in den von der Rückseite her Leuchtdioden in eine dafür vorgesehene Aussparung ragen.

Ferner ist aus dem Dokument US-A-3 267 598 eine Matrixanordnung bekannt, bei der Beleuchtungskörper und die für deren Stromversorgung notwendigen Leiterbahnen auf der Rückseite eines Lichtleiters befestigt sind.

Weiter ist es aus dem Dokument DE-A1-33 31 724 bekannt, eine passive Anzeige mit einer Beleuchtungsvorrichtung zu versehen, deren Lichtleiter von wenigstens zwei Leuchtdioden, welche im Randbereich angeordnet sind, beleuchtbar ist.

Schließlich ist es aus dem Dokument JP-A-55 02 44 04 bekannt, hinter einer Leuchtdiode eine Reflektorplatte zur Bündelung des abgestrahlten Lichts vorzusehen.

Der Erfindung liegt die Aufgabe zugrunde, ein Zeigerinstrument der eingangs genannten Art so auszubilden, daß es auf möglichst einfache Weise verschiedenfarbig beleuchtet werden kann, kompakt ausgebildet ist und den im Gehäuse vorhandenen Platz optimal nutzt.

Die Lösung dieser Aufgabe erfolgt mit den im kennzeichnenden Teil des Patentanspruchs angegebenen Maßnahmen.

Durch diese Gestaltung des Zeigerinstrumentes genügt eine einzige Leuchtdiode, um es in Abhängigkeit von der Zeigerstellung oder nach anderen Gesichtspunkten unterschiedlichfarbig zu beleuchten. Dadurch ist das erfindungsgemäße Zeigerinstrument sehr einfach aufgebaut und hat eine geringe Baugröße, so daß es sich ganz besonders für den Einbau in ein Kraftfahrzeug eignet.

Gleichzeitig ist das Zeigerinstrument besonders kompakt ausgebildet, weil die Leuchtdiode auf der Rückseite des Lichtleiters befestigt ist und in eine Durchbrechung des Lichtleiters ragt.

Der im Gehäuse des Zeigerinstrumentes vorhandene Platz wird optimal genutzt, weil die elektronischen Bauteile auf der als Umlenkfäche dienenden Kegelfläche des Lichtleiters angeordnet sind.

Eine besonders wirksame Instrumentenbeleuchtung mit einer relativ schwachen Lichtquelle läßt sich erreichen, wenn zwischen dem Lichtleiter und der Leiterplatte ein Reflektor angeordnet ist.

Zur Verdeutlichung des Grundprinzips der Erfindung ist eine Ausführungsform und ein Lichtleiter in der Zeichnung dargestellt und nachfolgend beschrieben. Diese zeigt in

Fig. 1 ein erfindungsgemäß gestaltetes Zeigerinstrument in Explosionsdarsgtellung, ohne Gehäuse,

Fig. 2 eine Ansicht von unten auf einen Lichtleiter einer Ausführungsform der Erfindung,

Fig. 3 einen horizontalen Schnitt durch den Lichtleiter nach Fig. 2.

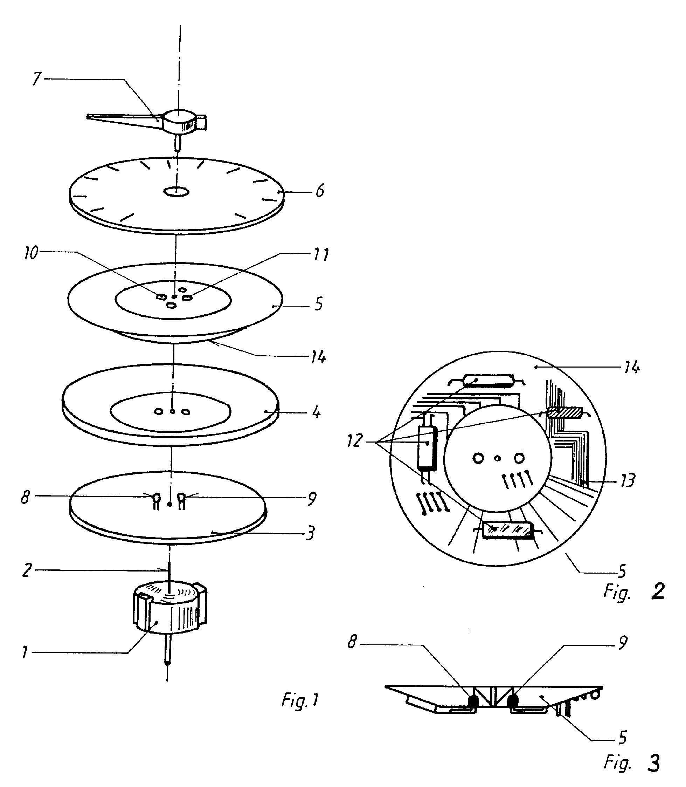

Die Figur 1 zeigt ein Meßwerk 1, bei dem es sich beispielsweise um ein Drehmagnet-Quotientenmeßwerk handelt. Das Meßwerk 1 hat eine Meßwerkwelle 2, welche im montierten Zustand des Zeigerinstrumentes eine Leiterplatte 3, einen Reflektor 4, einen Lichtleiter 5 und ein Ziffernblatt 6 durchdringt, so daß auf sie ein Zeiger 7 montiert werden kann.

Auf der Leiterplatte 3 sind zwei nach oben weisende Leuchtdioden 8, 9 angeordnet, welche so ausgebildet sind, daß sie je nach Ansteuerung in einer anderen Farbe leuchten. Im montierten Zustand des zeigerinstrumentes ragen diese Leuchtdioden 8, 9 durch den Reflektor 4 hindurch in jeweils eine Durchbrechung 10, 11 des Lichtleiters 5, so daß sie diesen zu beleuchten vermögen.

Bei einer in den Figuren 2 und 3 gezeigten Ausführungsform sind die elektrischen Bauteile 12 und die Leiterbahn 13 statt auf einer Leiterplatte 3 auf der Rückseite des Lichtleiters 5 angeordnet. Hierzu wird die als Umlenkfläche dienende Kegelfläche 14 des kegelscheibenförmigen Lichtleiters 5 genutzt.

In der Figur 3 ist zu sehen, daß die Leuchtdioden 8, 9 im Lichtleiter 5 befestigt sind. Die Leuchtdioden 8, 9 sind wiederum so gestaltet, daß sie je nach Ansteuerung in unterschiedlichen Farben leuchten. Verwendet man einen Lichtleiter mit elektronischen Bauteilen gemäß Figuren 2 und 3, dann benötigt man natürlich keine Leiterplatte 3 im Zeigerinstrument.

## Patentansprüche

1. Zeigerinstrument mit einem von wenigstens einer Leuchtdiode (8, 9) beleuchteten Lichtleiter (5), gekennzeichnet durch folgende Merkmale:
   – die Leuchtdiode (8, 9) ist eine ja nach Ansteuerung in verschiedenen Farben leuchtende Leuchtdiode,
   – die Leuchtdiode (8, 9) ist auf der Rückseite des Lichtleiters (5) befestigt und ragt in eine Durchbrechung (10, 11) des Lichtleiters (5),
   – die elektronischen Bauteile (12) sind auf der als Umlenkfläche dienenden Kegelfläche (14) des Lichtleiters (5) angeordnet.

## Claims

1. Pointer instrument with a light guide (5) illuminated by at least one light-emitting diode (8, 9), characterised by the following features:
   – the light-emitting diode (8, 9) is a light-emitting diode that lights up in different colours, according to how it is activated;
   – the light-emitting diode (8, 9) is fastened on the reverse of the light guide (5) and projects into a cutout (10, 11) in the light guide (5);
   – the electronic components (12) are arranged on the light guide's (5) conical surface (14), which acts as a baffle surface.

## Revendications

1. Instrument indicateur à aiguille comportant un organe conducteur de la lumière (5) éclairé par au moins une diode électroluminescente (8,9), instrument caractérisé par les propriétés suivantes:
   – la diode électroluminescente (8,9) est une diode électroluminescente qui, selon chaque fois son pilotage, éclaire en différentes couleurs.
   – la diode électroluminescente (8,9) est fixée sur la face arrière de l'organe conducteur de la lumière (5) et pénètre dans une découpe (10,11) de cet organe conducteur de la lumière (5),
   – les composants électroniques (12) sont disposés sur la surface conique (14), servant de surface de changement de direction, de l'organe conducteur de la lumière (5).

Fig. 1

Fig. 2

Fig. 3